# EUROPÄISCHE PATENTSCHRIFT

(11) **EP 1 342 269 B1**
(45) Veröffentlichungstag und Bekanntmachung des Hinweises auf die Patenterteilung: **28.11.2012**
(21) Anmeldenummer: 01270910.1
(22) Anmeldetag: 22.10.2001
(51) Int. Cl.: H01L 27/115, H01L 21/8247

(54) **NICHTFLÜCHTIGE HALBLEITERSPEICHERZELLE UND VERFAHREN ZU DEREN HERSTELLUNG**
NON-VOLATILE SEMICONDUCTOR MEMORY CELL AND METHOD FOR PRODUCING THE SAME
CELLULE MEMOIRE A SEMI-CONDUCTEUR NON VOLATILE ET SON PROCEDE DE FABRICATION

(30) Priorität: 14.12.2000 DE 10062245
(43) Veröffentlichungstag der Anmeldung: 10.09.2003
(73) Patentinhaber: Infineon Technologies AG, 85579 Neubiberg (DE)
(72) Erfinder: TEMPEL, Georg, B-1933 Sterrebeek (BE)
(74) Vertreter: Kindermann, Peter
(86) Internationale Anmeldenummer: PCT/DE2001/004006
(87) Internationale Veröffentlichungsnummer: WO 2002/049113

(56) Entgegenhaltungen:
- US-A- 5 589 413
- US-A- 6 107 670
- US-A- 6 136 652

## Beschreibung

Die vorliegende Erfindung bezieht sich auf eine nichtflüchtige Halbleiterspeicherzelle sowie eine zugehörige Halbleiterschaltungsanordnung und ein zugehöriges Herstellungsverfahren und insbesondere auf eine Flash-EPROM-Speicherzelle bzw. einen zugehörigen Speicher mit SNOR-Architektur, bei der jeweilige Source- und Drainleitungen selektiv angesteuert werden können.

Zum Speichern von größeren Datenmengen werden derzeit von Rechnereinheiten bzw. Computern in der Regel magnetische Plattenlaufwerke benutzt. Derartige Plattenlaufwerke benötigen jedoch einen relativ großen Platz und weisen eine Vielzahl von beweglichen Teilen auf. Folglich sind sie störanfällig und besitzen einen beträchtlichen Stromverbrauch. Darüber hinaus werden die zukünftigen Rechnereinheiten bzw. Computer sowie andere digitale Geräte wie beispielsweise digitale Kameras, Musikwiedergabegeräte oder Palm-Geräte immer kleiner, weshalb herkömmliche mechanische Speichereinrichtungen ungeeignet sind.

Als Alternative zu derartigen herkömmlichen mechanischen Speichereinrichtungen haben sich in letzter Zeit nichtflüchtige Halbleiterspeichereinrichtungen immer mehr durchgesetzt, wie beispielsweise FLASH-Speicher, E²PROM, EPROM und dergleichen. Als wichtigste Vertreter derartiger elektrisch löschbarer und elektrisch programmierbarer Speichereinrichtungen sind die so genannten NAND- sowie NOR-Halbleiterspeichereinrichtungen bekannt.

In beiden Halbleiterspeichereinrichtungen weisen die Speicherzellen so genannte Eintransistor-Speicherzellen auf, wobei üblicherweise in einem aktiven Gebiet eines Halbleitersubstrats ein Draingebiet und ein Sourcegebiet ausgebildet sind und sich über dem dazwischen liegenden Kanalabschnitt eine isolierte ladungsspeichernde Schicht befindet.

Aus der Druckschrift US-A-6 107 670, die den Oberbegriff des Patentanspruchs 1 bildet, ist eine nichtflüchtige Halbleiterspeicherzelle mit in einem Substrat ausgebildeten Source-/Draingebieten und auf einer ersten Isolierschicht ausgebildeten Wortleitungsstapeln mit einer ladungsspeichernden Schicht, einer zweiten Isolierschicht sowie einer Steuerschicht bekannt, wobei die Wortleitungsstapel von einer isolierenden Schutzschicht umgeben sind und eine dritte Isolierschicht ganzflächig auf dem Substrat und den isolierten Wortleitungsstapeln ausgebildet ist.

Aufgrund der "common source"-Architektur sind die Sourcegebiete hierbei durch ein gemeinsames Dotiergebiet im Substrat elektrisch miteinander verbunden. Die Draingebiete werden hingegen über in der dritten Isolierschicht ausgebildete Kontaktlöcher kontaktiert und mit einer an der Oberfläche der dritten Isolierschicht ausgebildeten streifenförmigen Bitleitung verbunden. Nachteilig sind bei einer derartigen "common source"-Architektur relative hohe Anschlusswiderstände für die Sourcegebiete sowie das Fehlen einer selektiven Anwahl von Speicherzellen.

In ähnlicher Weise sind auch in NAND-Halbleiterschaltungsanordnungen eine Vielzahl von Schaltelementen seriell miteinander verbunden sind und können über ein gemeinsames Auswahlgatter bzw. einen Auswahltransistor angesteuert werden. Demgegenüber sind die jeweiligen Schaltelemente in NOR-Halbleiter-Schaltungsanordnungen parallel bzw. matrixförmig organisiert, wodurch jedes Schaltelement einzeln ausgewählt werden kann.

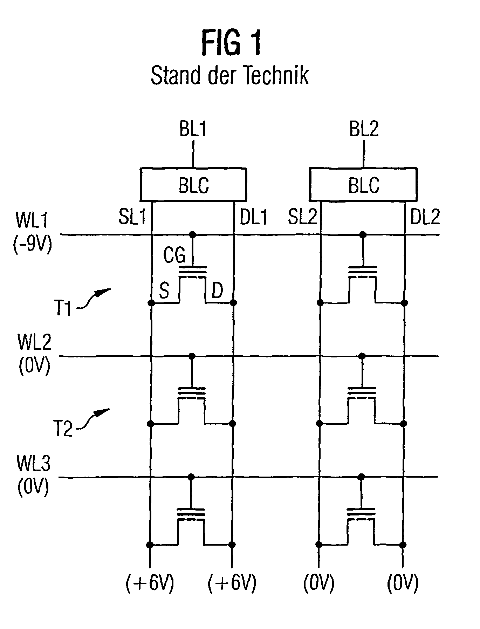

Figur 1 zeigt eine vereinfachte Darstellung einer herkömmlichen SNOR-Halbleiterschaltungsanordnung (selective NOR), bei der im Gegensatz zur NOR-Halbleiter-Schaltungsanordnuung mit "common source"-Architektur die einzelnen Schaltelemente (T1, T2, ...) selektiv sowohl über eine jeweilige Sourceleitung (SL1, SL2, ...) als auch über eine jeweilige Drainleitung (DL1, DL2, ...) angesteuert werden. Diese selektive Ansteuerung wird beispielsweise über jeweilige Bitleitungssteuerungen BLC durchgeführt, welche sozusagen die gemeinsamen Bitleitungen BL1, BL2,... realisieren. Auf diese Weise können weitere Shrinks bzw. eine weitergehende Integration der Halbleiter-Schaltungsanordnung durchgeführt werden, da die SNOR-Architektur nicht auf eine vorbestimmte Mindest-Zelltransistorlänge bzw. Kanallänge angewiesen ist.

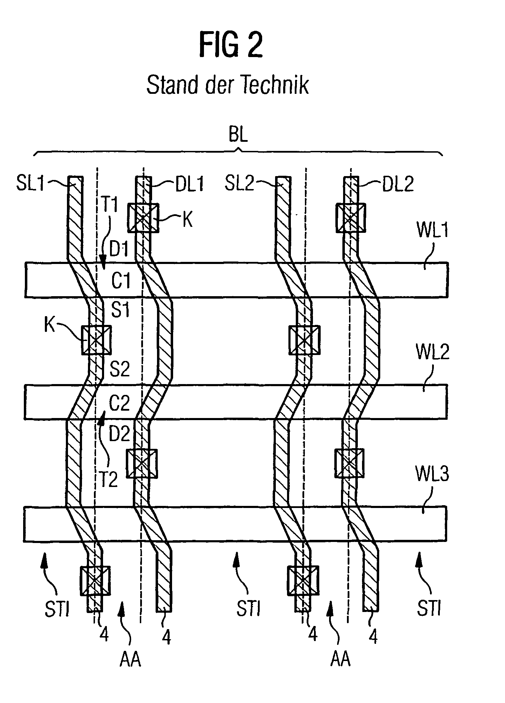

Figur 2 zeigt eine vereinfachte Darstellung eines herkömmlichen Layouts der SNOR-Halbleiterschaltungsanordnung gemäß Figur 1. Gemäß Figur 2 werden die Schaltelemente T1, T2, ... in aktiven Bereichen eines Halbleitersubstrats ausgebildet, die eine im Wesentlichen gerade streifenförmige Struktur aufweisen. Die Vielzahl von spaltenweise angeordneten streifenförmigen aktiven Bereichen AA werden zeilenweise von ebenfalls streifenförmig ausgebildeten Schichtstapeln überlagert, wobei eine oberste Schicht eine Steuerschicht bzw. Wortleitung WL1 bis WL3 der Schaltelemente T1, T2, ... darstellt. Jeder Kreuzungspunkt bzw. Überlappungsbereich eines derartigen streifenförmigen aktiven Bereiches AA mit einer streifenförmig ausgebildeten Wortleitung WL1 bis WL3 stellt somit eine Vielzahl von Schaltelementen T dar. Zum Kontaktieren von jeweiligen Draingebieten D und Sourcegebieten S sind Kontakte K notwendig, die üblicherweise im aktiven Bereich AA ausgebildet sind, oftmals jedoch in ein angrenzendes Isolationsgebiet STI (Shallow Trench Isolation) reichen können. In einer weiteren darüber liegenden Schicht, die vorzugsweise eine erste Metallisierungsschicht darstellt, befinden sich nunmehr die Sourceleitungen SL1, SL2, ... sowie die Drainleitungen DL1, DL2, ... für die jeweiligen Bitleitungen BL. Die Drainleitungen stehen hierbei über entsprechende Kontakte K mit den dazugehörigen Draingebieten D des aktiven Bereiches in Verbindung, wobei in gleicher Weise die Sourceleitungen SL1 über entsprechende Kontakte mit den dazugehörigen Sourcegebieten in Verbindung stehen.

Nachteilig ist jedoch bei einem derartigen herkömmlichen Layout, dass auf Grund der zusätzlichen Sourceleitungen im Vergleich zu einer "common source"-Architektur eine mehr als doppelt so intensive Metallisierung vorliegt, was einen begrenzenden Faktor für eine weitergehende Integration bzw. weitere Shrinks darstellt. Üblicherweise besitzen daher derartige herkömmliche SNOR-Halbleiterspeicherzellen eine Fläche von mindestens 12 F² und typischen 20 F², wobei F eine kleinste lithografisch realisierbare Strukturbreite darstellt. Darüber hinaus ergeben sich insbesondere bei mäanderförmig ausgestalteten Source- und Drainleitungen so genannte Lithografie-Artefakte, die zu einer Verjüngung bis hin zu Unterbrechungen der jeweiligen Leitungen führen können.

Aus der Druckschrift US-A-5 589 413 ist eine weitere herkömmliche nichtflüchtige Halbleiterspeicherzelle mit "common source"-Architektur bekannt, wobei eine Schichtenfolge aus einem Tunneloxid, einem Floating Gate, einer ONO-Schicht und einer Steuerschicht einen Wortleitungsstapel ausbildet. Ferner zeigt die Druckschrift US-A-6 136 652 eine Split-Gate-Speicherzelle sowie ein zugehöriges Herstellungsverfahren, wobei die Source- und Drainleitungen als Diffusionsgebiete im Substrat ausgebildet sind. Zur Verbesserung einer Leitfähigkeit können hierbei zusätzliche Source- und Drainleitungen in einer Metallisierungsebene angeordnet sein, welche die darunter liegenden Diffusionsleitungen kontaktieren.

Der Erfindung liegt daher die Aufgabe zu Grunde, eine nichtflüchtige Halbleiterspeicherzelle, eine zugehörige Halbleiterschaltungsanordnung sowie ein Herstellungsverfahren zu schaffen, wobei sich bei verbesserten elektrischen Eigenschaften eine weitere Integration auf einfache Weise realisieren lässt.

Erfindungsgemäß wird diese Aufgabe hinsichtlich der Halbleiterspeicherzelle durch die Merkmale des Patentanspruchs 1, hinsichtlich der Halbleiterschaltungsanordnung durch die Merkmale des Patentanspruchs 8 und hinsichtlich des Herstellungsverfahrens durch die Maßnahmen des Patentanspruchs 9 gelöst.

Insbesondere durch die Verwendung von Öffnungen in der dritten Isolierschicht sowohl für die Sourcegebiete als auch für die Draingebiete und von isolierenden Stegen, an deren Seitenwänden jeweils eine Sourceleitung und eine Drainleitung ausgebildet sind, wobei die Source- und Drainleitungen als Spacer und voneinander getrennt zwischen zwei unmittelbar benachbarten isolierenden Stegen ausgebildet sind und die Source- und Draingebiete über die Öffnungen jeweils unmittelbar berühren, erhält man neben verbesserten Anschlusswiderständen sublithografische Strukturbreiten für die Source- und Drainleitungen, wodurch eine Gesamtzellfläche bis auf 5F² verringert werden kann. Auf diese Weise kann eine Speicherdichte wesentlich erhöht werden, wodurch sich die Kosten pro Speichereinheit verringern.

Vorzugsweise bestehen die Source- und Drainleitungen aus insitu-dotiertem Polysilizium, wodurch sich bei guter Leitfähigkeit die Herstellung besonders einfach realisieren lässt.

Die vierte Isolierschicht stellt vorzugsweise eine selektive Ätzstoppschicht für die Source- und Drainleitungen sowie für den isolierenden Steg dar, wodurch sich das Herstellungsverfahren weiter vereinfachen lässt und die Source- und Drainleitungen besonders einfach und zuverlässig ausgebildet werden können. Insbesondere eine Siliziumnitridschicht kann hierbei in vorteilhafter Weise als dritte Isolierschicht verwendet werden, wodurch sich eine hohe Selektivität für die aus Polysilizium bestehenden Source- und Drainleitungen und eine aus beispielsweise TEOS-Oxid bestehenden isolierenden Steg beim Ätzen ergibt.

Als ladungsspeichernde Schicht wird vorzugsweise eine elektrisch leitende oder elektrisch nicht leitende Schicht verwendet.

Zur Vermeidung von sogenannten Grabenätzungen im aktiven Bereich können die Source-/Drainleitungen und/oder die Öffnungen derart ausgebildet werden, dass sie sich überlappen, wodurch zwar auf Kosten der Zellgröße eine verbesserte Kontaktierung gewährleistet ist.

In den weiteren Ansprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: ein vereinfachtes Ersatzschaltbild einer herkömmlichen Halbleiterschaltungsanordnung;
- Figur 2: eine vereinfachte Draufsicht der herkömmlichen Halbleiterschaltungsanordnung gemäß Figur 1;
- Figur 3: eine vereinfachte Draufsicht von ersten Herstellungsschritten zur Realisierung der erfindungsgemäßen Halbleiterschaltungsanordnung;
- Figur 4: eine zum Ausbilden der erfindungsgemäßen Öffnungen benötigte Maske;
- Figur 5: eine vereinfachte Draufsicht von weiteren Herstellungsschritten zur Realisierung der erfindungsgemäßen Halbleiterschaltungsanordnung;
- Figur 6: eine vereinfachte Schnittansicht der erfindungsgemäßen Halbleiterschaltungsanordnung gemäß einem Schnitt A-A' in Figur 5;
- Figur 7: eine vereinfachte Schnittansicht der erfindungsgemäßen Halbleiterschaltungsanordnung gemäß einem Schnitt B-B' in Figur 5;
- Figur 8: eine teilvergrößerte Schnittansicht der erfindungsgemäßen Halbleiterschaltungsanordnung gemäß einem weiteren Ausführungsbeispiel; und
- Figur 9: eine vereinfachte Schnittansicht der erfindungsgemäßen Halbleiterschaltungsanordnung gemäß einem Schnitt C-C' in Figur 5.

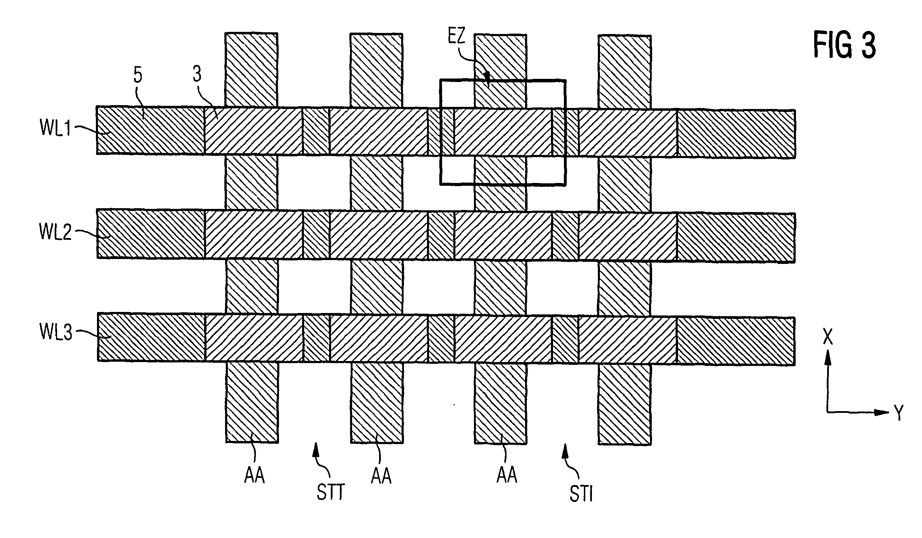

Figur 3 zeigt eine vereinfachte Draufsicht der erfindungsgemäßen Halbleiterschaltungsanordnung mit SNOR-Architektur nach einer Vielzahl von ersten Herstellungsschritten.

Zur Herstellung der in Figur 3 dargestellten SNOR-Halbleiterschaltungsanordnung werden zunächst die nachfolgend beschriebenen, jedoch nicht näher dargestellten Herstellungsschritte durchgeführt. Zunächst werden in einem Substrat 1 (z.B. Si-Halbleitersubstrat) im Wesentlichen gerade aktive Bereiche AA beispielsweise mittels Grabenisolierung ausgebildet, wobei insbesondere eine flache Grabenisolierung (shallow trench isolation, STI) Verwendung findet. Da die aktiven Bereiche AA im Wesentlichen gerade ausgebildet sind, ergeben sich bei der Lithografie keinerlei Probleme auf Grund von Kanten oder komplizierten geometrischen Formen.

Anschließend wird auf einer Waferoberfläche bzw. im Bereich der aktiven Bereiche AA eine erste Isolierschicht 2 ganzflächig ausgebildet, die vorzugsweise eine Tunneloxidschicht darstellt und beispielsweise als thermisches Siliziumdioxid ausgebildet wird. Die erste Isolierschicht 2 kann jedoch in gleicher Weise auch mittels eines Abscheideverfahrens oder anderweitig ausgebildet werden. Im bevorzugten Ausführungsbeispiel besteht ein Schaltelement aus einer Eintransistor-Speicherzelle EZ, weshalb in einem nachfolgenden Schritt eine ladungsspeichernde Schicht 3 vorzugsweise durch Abscheiden von Polysilizium als "floating gate" ausgebildet wird. Die Erfindung ist jedoch nicht auf eine derartig elektrisch leitende Ladungsspeicherschicht beschränkt sondern umfasst in gleicher Weise auch elektrisch nicht leitende ladungsspeichernde Schichten, wie sie beispielsweise in sogenannten SONOS-Zellen verwendet werden.

Zur Realisierung von elektrisch voneinander getrennten ladungsspeichernden Schichten kann nunmehr in einem weiteren Herstellungsschritt ein erstes Strukturieren der ladungsspeichernden Schicht 3 in einer x-Richtung erfolgen, wobei die streifenförmige ladungsspeichernde Schicht zunächst in Richtung der aktiven Bereiche AA ausgebildet werden. Nach diesem Strukturierungsschritt, der üblicherweise mittels fotolithografischer Prozesse durchgeführt wird, werden in nachfolgenden Herstellungsschritten eine zweite Isolierschicht 4, eine erste leitende Schicht 5 und eine Teil-Schutzschicht 6 auf dem Wafer abgeschieden. Als zweite Isolierschicht 4 wird als sogenanntes Koppeloxid vorzugsweise eine Schichtenfolge aus Oxid/Nitrid/Oxid (ONO) abgeschieden, wobei auch andere dielektrische Schichten mit hohem Er verwendet werden können. Als erste leitende Schicht 5 wird beispielsweise eine weitere hochdotierte.elektrisch leitende Polysiliziumschicht abgeschieden, die eine spätere Wortleitung realisiert. Als Teil-Schutzschicht 6 wird vorzugsweise eine Hartmaske verwendet.

In einem nachfolgenden Herstellungsschritt werden unter Verwendung eines (nicht dargestellten) Resists mittels herkömmlicher Lithografie im Wesentlichen gerade Wortleitungsstapel durch Strukturieren der Teil-Schutzschicht 6, der Steuerschicht 5 und der zweiten Isolierschicht 4 vorzugsweise durch Trockenätzen unter Verwendung der Teil-Schutzschicht 6 als. Maske in y-Richtung geätzt und nachfolgend in gleicher Weise die zweite Isolierschicht 4 sowie die ladungsspeichernde Schicht 3 selektiv zur ersten Isolierschicht 2 entfernt, wodurch Inseln der ladungsspeichernden Schicht 3 ausgebildet werden. Abschließend erfolgt eine Nachbehandlung des geätzten Wortleitungsstapels, wobei beispielsweise Polymere entfernt werden und die Waferoberfläche gereinigt wird.

In einem optionalen zusätzlichen Herstellungsschritt können an den Seitenwänden der Wortleitungsstapel Seitenisolierschichten 8 vorzugsweise als Oxid ausgebildet werden, wobei beispielsweise eine thermische Oxidation durchgeführt wird. Anschließend werden Source-/Draingebiete S/D in den aktiven Bereichen AA des Halbleitersubstrats 1 vorzugsweise durch Ionenimplantation unter Verwendung der Wortleitungsstapel selbstjustierend ausgebildet, wobei üblicherweise symmetrische Übergänge verwendet werden. Unsymmetrische p/n-Übergänge können beispielsweise durch zusätzliche Maskierschritte realisiert werden.

Anschließend werden an den Seitenwänden der Wortleitungsstapel sogenannte Spacer 7 als weiterer Teil der Schutzschicht für die Halbleiterspeicherzelle ausgebildet, wobei beispielsweise ein Abscheiden und anisotropes Zurückätzen einer isolierenden Schicht durchgeführt wird.

Nach Entfernen der ersten Isolierschicht 2, die auch schon zu einem früheren Zeitpunkt entfernt werden kann, erhält man die in Figur 3 dargestellte Draufsicht der erfindungsgemäßen SNOR-Halbleiterschaltungsanordnung.

In einem nachfolgenden Herstellungsschritt wird eine dritte Isolierschicht 9 ganzflächig auf dem Wafer ausgebildet. Vorzugsweise wird hierfür eine selektiv für nachfolgende Schichten wirkende Ätzstoppschicht als dritte Isolierschicht 9 ausgebildet. Beispielsweise kann als derartige Ätzstoppschicht ein Siliziumnitrid ganzflächig mit einer ausreichenden Dicke abgeschieden werden.

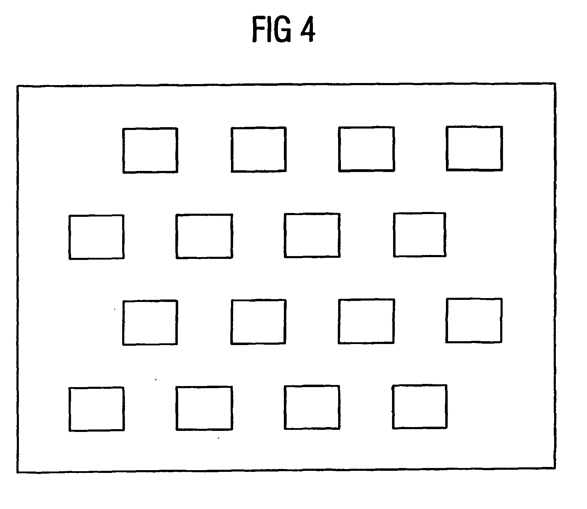

Unter Verwendung einer in Figur 4 dargestellten Maske werden anschließend beispielsweise mittels eines kurzen Trockenätzprozesses vorbestimmte Öffnungen O in dieser dritten Isolierschicht 9 ausgebildet, die im Wesentlichen zwischen den jeweiligen Wortleitungsstapeln liegen und die aktiven Bereiche AA zumindest teilweise freilegen.

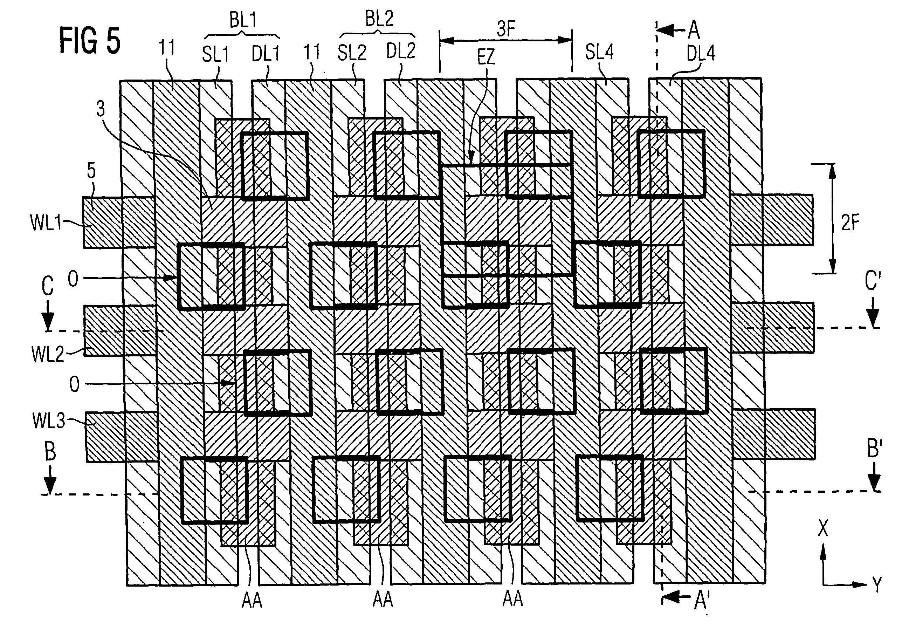

Gemäß Figur 5 befinden sich die Öffnung O unmittelbar zwischen zwei benachbarten Wortleitungsstapeln bzw. Wortleitungen WL1, WL2, WL3, ... und sind im Wesentlichen zickzackförmig derart über dem aktiven Bereich AA ausgebildet, dass dieser zur Hälft bzw. lediglich teilweise freigelegt wird. Gemäß Figur 5 besitzen die Öffnungen O eine quadratische Form. Sie können jedoch auch eine beliebige andere Form aufweisen und insbesondere verkleinert bzw. vergrößert und/oder zum aktiven Bereich AA verschoben angeordnet sein, wodurch sogenannte Grabenprobleme, die später beschrieben werden, beseitigt werden können.

Gemäß Figur 5 wird in nachfolgenden Herstellungsschritten nach dem Ausbilden dieser Öffnungen O in der dritten Isolierschicht 9 eine isolierende Stegschicht 11 (Dummyschicht) ganzflächig ausgebildet und im Wesentlichen in x-Richtung lithografisch strukturiert, wodurch sich isolierende Stege 11 ergeben, die gemäß Figur 5 beispielsweise zwischen jeweiligen aktiven Bereichen AA angeordnet sind. Auf diese Weise können in vorteilhafter Art auftretende Höhenunterschiede, die sich insbesondere durch die ladungsspeichernden Schichten bzw. Inseln 3 ergeben, ausgeglichen werden. Grundsätzlich können jedoch derartige isolierende Stege 11 auch unmittelbar über den aktiven Bereichen AA angeordnet werden. Beispielsweise kann als Stegschicht bzw. für die isolierenden Stege 11 ein Oxid als sogenannte Dummy-Schicht abgeschieden und strukturiert werden. Insbesondere bei Verwendung eines derartigen Siliziumoxids ergibt sich ein selektiver Ätzprozess zu der als Ätzstoppschicht verwendeten dritten Isolierschicht 9.

In einem nachfolgenden Herstellungsschritt wird nunmehr eine Bitleitungsschicht 10 ganzflächig auf dem Wafer abgeschieden und in einem nachfolgenden Verfahrensschritt derart zurückgebildet, dass sich Source- und Drainleitungen SL1, DL1, SL2, DL2, ... an Seitenwänden der isolierenden Stege 11 ergeben. Beispielsweise kann hierbei eine Abscheidung von insitudotiertem Polysilizium durchgeführt werden, wobei die Source-und Drainleitungen anschließend mittels einer Spacerätzung strukturiert werden. Als Spacerätzung wird hierbei ein anisotropes Trockenätzen verwendet, bei dem die Bitleitungsschicht im Wesentlichen nur in einer Richtung abgetragen wird. Auf Grund der verwendeten isolierenden Stege 11 und der nachfolgenden Rückbildung der Bitleitungsschicht ergeben sich bei entsprechender Dicke für die Bitleitungsschicht 10 sublithografische Source- und Drainleitungen SL1 bis DL2, die mit einem ausreichenden Abstand innerhalb zweier lithografisch ausgebildeter Stege liegen.

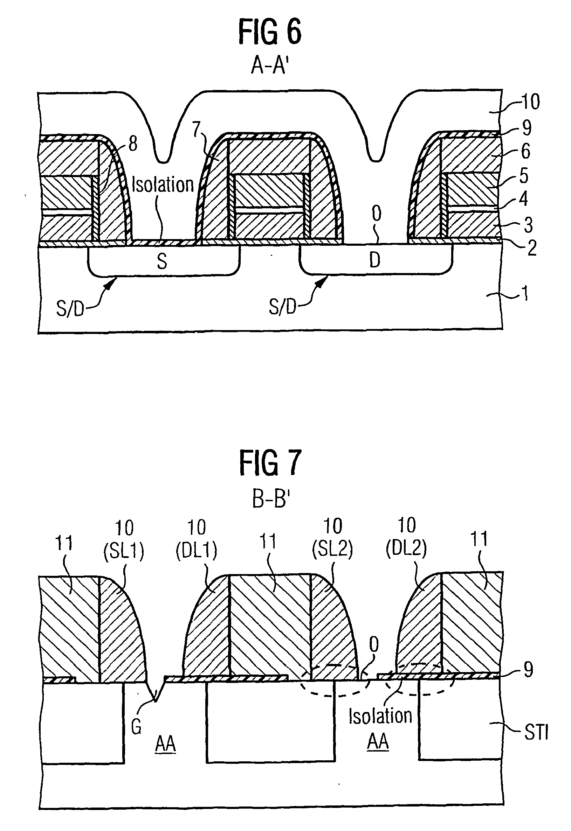

Figur 6 zeigt eine vereinfachte Schnittansicht der erfindungsgemäßen SNOR-Halbleiterschaltungsanordnung gemäß einem Schnitt A-A' in Figur 5, wobei gleiche Bezugszeichen gleiche oder entsprechende Schichten bezeichnen, weshalb auf eine wiederholte Beschreibung nachfolgend verzichtet wird.

Gemäß Figur 6 wird auf Grund der zickzackförmig angeordneten Öffnung O lediglich jedes zweite Source-/Draingebiet S/D freigelegt, während der restliche Teil ganzflächig von der dritten Isolierschicht 9 bedeckt ist. Demzufolge ergibt sich für die an der Seitenwand des isolierenden Stegs 11 ausgebildete Drainleitung DL4 nur für jedes zweite Source-/Draingebiet eine unmittelbare Berührung mit dem aktiven Bereich AA. Demzufolge können alle Draingebiete mit der jeweiligen Drainleitung (z.B. DL4) kontaktiert werden, während eine in Figur 6 nicht dargestellte Sourceleitung SL4 die weiteren Sourcegebiete S kontaktiert. Zur Ausbildung eines ohmschen Kontakts weisen die Bitleitungsschicht 10 und die jeweiligen Source-/Draingebiete S/D jeweils den gleichen Leitungstyp (p oder n) auf. Bei Verwendung von Metallen für die Bitleitungsschicht ist der Leitungstyp jedoch nicht von Bedeutung.

Figur 7 zeigt eine weitere vereinfachte Schnittansicht der erfindungsgemäßen SNOR-Halbleiterschaltungsanordnung gemäß einem Schnitt B-B' in Figur 5, wobei gleiche Bezugszeichen wiederum gleiche Schichten bezeichnen und auf eine wiederholte Beschreibung nachfolgend verzichtet wird.

Gemäß Figur 7 kann bei einer vorbestimmten Form und Größe der Öffnungen O in der dritten Isolierschicht 9 sowie einer vorbestimmten Dicke der Bitleitungsschicht 10 bzw. der dazugehörigen Sourceleitungen und Drainleitungen eine Überätzung im aktiven Bereich AA stattfinden, wodurch sogenannte Gräben G im Substrat bzw. im aktiven Bereich an der Kante bzw. dem Rand der dritten Isolierschicht 9 ausgebildet werden. Auf diese Weise können sich verringerte Leitfähigkeiten in den Source-/Draingebieten S/D ergeben oder die grundsätzliche Funktionsfähigkeit beeinträchtigt werden.

Zur Vermeidung einer derartigen Überätzung beim Ausbilden der Source- und Drainleitungen SL1 bis DL2 können die Öffnungen O sowie die Source- und Drainleitungen derart dimensioniert bzw. verschoben werden, dass sich eine Überlappung ergibt und eine Ausbildung von Gräben zuverlässig verhindert wird.

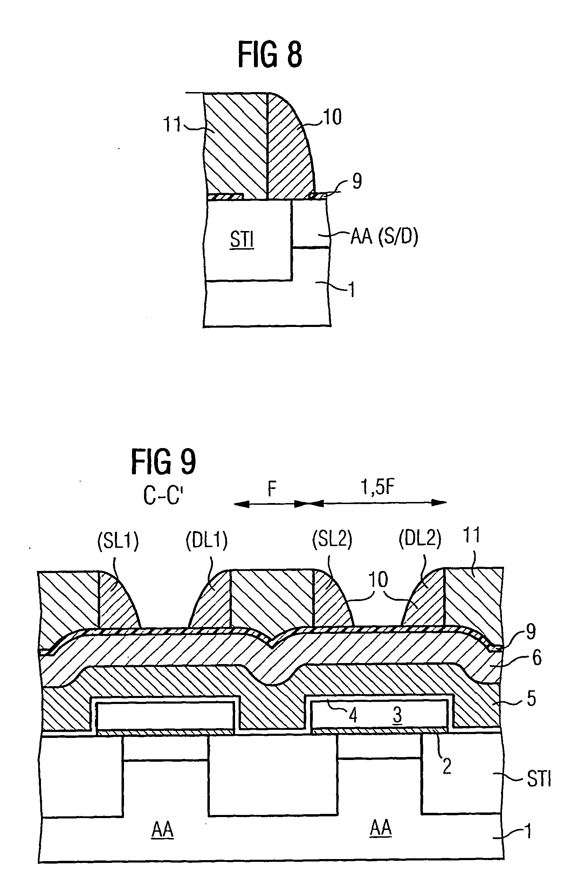

Figur 8 zeigt eine Teil-Schnittansicht von Figur 7 für ein derartiges weiteres Ausführungsbeispiel, wobei die Öffnungen in der dritten Isolierschicht 9 derart verkleinert sind, dass die ausgebildeten Source- und Drainleitungen bzw. die dazugehörige Bitleitungsschicht 10 einen ausreichenden Überlapp aufweist. Zur Realisierung eines derartigen Überlappbereichs kann in gleicher Weise eine Dicke der Bitleitungsschicht 10 oder eine Positionierung der Öffnungen O variiert werden. Auf diese Weise erhält man eine zuverlässige Kontaktierung mit den jeweiligen Source-/Draingebieten S/D im aktiven Bereich AA des Substrats 1, ohne dass die Gefahr einer Grabenausbildung besteht.

Figur 9 zeigt eine vereinfachte Schnittansicht der erfindungsgemäßen Halbleiterschaltungsanordnung gemäß einem Schnitt C-C' in Figur 5, wobei gleiche Bezugszeichen gleiche Schichten bezeichnen und nachfolgend auf eine wiederholte Beschreibung verzichtet wird.

Gemäß Figur 9 wird die wesentliche Verringerung der Zellgröße sichtbar, wonach im günstigsten Fall für die aktiven Bereiche AA und die isolierenden Stege 11 mit ihren Source- und Drainleitungen SL1 bis DL2 lediglich 2,5 x F benötigt werden. Bei einer typischen Zellbreite von 2 F ergibt sich daraus eine minimale Zellfläche von 2,5F x 2F = 5 F² gegenüber minimal 12 F² gemäß dem Stand der Technik. Unter Verwendung von üblichen Justiertoleranzen ergibt sich gemäß der vorliegenden Erfindung eine Zellfläche von typisch 6 F² gegenüber typischen 20 F² gemäß dem Stand der Technik. Demzufolge ergibt sich eine wesentliche Verringerung der Zellfläche selbst bei Verwendung von grundsätzlich flächenintensiven SNOR-Halbleiterspeicherzellen.

Die Erfindung wurde vorstehend anhand einer Siliziumnitridschicht, einer Oxidschicht und einer Polysiliziumschicht für die dritte Isolierschicht, die Stegschicht und die Bitleitungsschicht beschrieben. Sie ist jedoch nicht darauf beschränkt und umfasst vielmehr alle weiteren Materialien für diese Schichten, bei denen die dritte Isolierschicht als selektive Ätzstoppschicht für die darüber liegenden Schichten wirkt. In gleicher Weise besteht die ladungsspeichernde Schicht 3 aus einer elektrisch leitenden Schicht. Sie kann jedoch in gleicher Weise aus einer elektrisch nicht leitenden Schicht bestehen und eine Einzel- oder Mehrfach-Schichtstruktur aufweisen. Die Bitleitungsschicht wurde als insitu-dotierte Polysiliziumschicht abgeschieden; sie kann jedoch in gleicher Weise auch aus einer sonstigen elektrisch leitenden Schicht bestehen oder eine Mehrfachschichtstruktur wie z.B. siliziertes Silizium aufweisen.

Ferner kann zum Entfernen von Endbereichen der Source- und Drainleitungen am Ende der isolierenden Stege 11 ein weiterer Ätzschritt verwendet werden, wodurch Kurzschlüsse zwischen diesen Leitungen zuverlässig entfernt werden können.

Ferner können die Öffnungen O auch im Wesentlichen geradlinig angeordnet sein, wobei sich in diesem Fall jedoch eine mäanderförmige Struktur bzw. zickzackförmige Struktur für die isolierenden Stege und die dazugehörigen Source- und Drainleitungen ergeben.

## Patentansprüche

1. Nichtflüchtige Halbleiterspeicherzelle mit einem in einem Substrat (1) ausgebildeten aktiven Bereich (AA) zur Realisierung von Source-/Draingebieten (S/D);
einer auf dem Substrat (1) ausgebildeten ersten Isolierschicht (2);
einer auf der ersten Isolierschicht (2) ausgebildeten ladungsspeichernden Schicht (3),
einer auf der ladungsspeichernden Schicht (3) ausgebildeten zweiten Isolierschicht (4), sowie
einer auf der zweiten Isolierschicht (4) ausgebildeten Steuerschicht (5), die gemeinsam Wortleitungsstapel (WLx) realisieren;
einer zumindest die Wortleitungsstapel (WLx) umgebenden isolierenden Schutzschicht (6, 7, 8); und
einer dritten Isolierschicht (9), die ganzflächig auf dem Substrat (1) und den isolierten Wortleitungsstapeln (WLx) ausgebildet ist, **dadurch gekennzeichnet, dass**
die dritte Isolierschicht (9) Öffnungen (O) über zumindest Teilbereichen der Source- und Draingebiete (S/D) aufweist; und
auf der dritten Isolierschicht (9) isolierende Stege (11) senkrecht zu den Wortleitungsstapeln (WLx) ausgebildet sind, an deren Seitenwänden jeweils eine Sourceleitung (SL2) und eine Drainleitung (DL1) ausgebildet sind, wobei zwischen zwei unmittelbar benachbarten isolierenden Stegen (11) die Sourceleitung (SL1) und die Drainleitung (DL1) als Spacer und getrennt voneinander ausgebildet sind, und wobei
die Source- und Drainleitung (SL1, DL1) die Source-/Draingebiete (S/D) über die Öffnungen (O) in der dritten Isolierschicht (9) jeweils unmittelbar berühren.

2. Nichtflüchtige Halbleiterspeicherzelle nach Patentanspruch 1,
**dadurch gekennzeichnet, dass** die Source- und Drainleitung (SL2, DL1) dotiertes Polysilizium aufweisen.

3. Nichtflüchtige Halbleiterspeicherzelle nach einem der Patentansprüche 1 oder 2,
**dadurch gekennzeichnet, dass** der isolierende Steg (11) TEOS-Oxid aufweist.

4. Nichtflüchtige Halbleiterspeicherzelle nach einem der Patentansprüche 1 bis 3,
**dadurch gekennzeichnet, dass** die dritte Isolierschicht (9) eine Nitridschicht aufweist.

5. Nichtflüchtige Halbleiterspeicherzelle nach einem der Patentansprüche 1 bis 4,
**dadurch gekennzeichnet, dass** die ladungsspeichernde Schicht (3) eine elektrisch leitende oder elektrisch nicht leitende Schicht aufweist.

6. Nichtflüchtige Halbleiterspeicherzelle nach einem der Patentansprüche 1 bis 5,
**dadurch gekennzeichnet, dass** die Source- und Drainleitungen (SL1, DL1) die Öffnungen (O) teilweise oder vollständig abdecken.

7. Nichtflüchtige Halbleiterspeicherzelle nach einem der Patentansprüche 1 bis 6,
**dadurch gekennzeichnet, dass** die erste Isolierschicht (2) ein Tunneloxid und die zweite Isolierschicht (4) ein Koppeloxid aufweist.

8. Nichtflüchtige Halbleiterschaltungsanordnung mit einer Vielzahl von matrixförmig angeordneten Halbleiterspeicherzellen nach einem der Patentansprüche 1 bis 7,
**dadurch gekennzeichnet, dass** die aktiven Bereiche (AA), die isolierenden Stege (11) und die jeweiligen Source- und Drainleitungen (SL1, DL1) spaltenförmig angeordnet sind;
die Steuerschichten (5) zum Ausbilden von Wortleitungen im Wesentlichen zeilenförmig angeordnet sind; und
die Öffnungen (O) in der dritten Isolierschicht (9) im Wesentlichen derart zickzackförmig angeordnet sind, dass die aktiven Bereiche (AA) zumindest teilweise frei liegen.

9. Verfahren zum Herstellen einer Halbleiterschaltungsanordnung mit den Schritten:
a) Ausbilden von im Wesentlichen geraden aktiven Bereichen (AA) in einem Substrat (1);
b) Ausbilden einer ersten Isolierschicht (2) auf dem Substrat (1) und einer ladungsspeichernden Schicht (3) auf der ersten Isolierschicht (2);
c) Strukturieren der ladungsspeichernden Schicht (3) in einer x-Richtung;
d) Ausbilden einer zweiten Isolierschicht (4) auf der ladungsspeichernden Schicht (3), einer Steuerschicht (5) auf der zweiten Isolierschicht (4) und einer Teil-Schutzschicht (6) auf der Steuerschicht (5);
e) Strukturieren der Teil-Schutzschicht (6), der Steuerschicht (5), der zweiten Isolierschicht (4) und der ladungsspeichernden Schicht (3) in einer y-Richtung zum Ausbilden von im Wesentlichen geraden Wortleitungsstapeln (WLx);
f) Ausbilden von Source-/Draingebieten (S/D) im aktiven Bereich (AA) des Substrats (1);
g) Ausbilden von Spacern (7) an den Seitenwänden der Wortleitungsstapel (WLx) und Entfernen der nicht bedeckten ersten Isolierschicht (2);
h) ganzflächiges Ausbilden einer dritten Isolierschicht (9) auf dem Substrat (1);
i) Ausbilden von Öffnungen (O) in der dritten Isolierschicht (9) zum zumindest teilweisen Freilegen der aktiven Bereiche (AA);
j) Ausbilden einer isolierenden Stegschicht (11) auf der dritten Isolierschicht (9);
k) Strukturieren der Stegschicht in einer y-Richtung zum Ausbilden von isolierenden Stegen (11) senkrecht zu den Wortleitungsstapeln (WLx);
l) Ausbilden einer Bitleitungsschicht (10); und
m) Rückbilden der Bitleitungsschicht (10) zum Ausbilden von Source- und Drainleitungen (SL1, DL1) an Seitenwänden der isolierenden Stege (11), wobei zwischen zwei unmittelbar benachbarten isolierenden Stegen die Sourceleitung (SL1) und die Drainleitung (DL1) als Spacer und getrennt voneinander ausgebildet sind.

10. Verfahren nach Patentanspruch 9,
**dadurch gekennzeichnet, dass** in Schritt m) ein anisotropes Trockenätzen durchgeführt wird.

11. Verfahren nach einem der Patentansprüche 9 oder 10,
**dadurch gekennzeichnet, dass** das Ausbilden der Öffnungen (O) in Schritt i) und das Rückbilden in Schritt m) derart durchgeführt wird, dass die Source- und Drainleitungen (SL2, DL1) die dritte Isolierschicht (9) an den Öffnungen (O) überlappen.

12. Verfahren nach einem der Patentansprüche 9 bis 11,
**gekennzeichnet durch** den weiteren Schritt n) Entfernen von Endbereichen der Source- und Drainleitungen (SL1, DL1) am Ende der isolierenden Stege (11).

13. Verfahren nach einem der Patentansprüche 9 bis 12,
**dadurch gekennzeichnet, dass** in Schritt l) eine insitu-dotierte Polysiliziumschicht als Bitleitungsschicht (10) abgeschieden wird.

14. Verfahren nach einem der Patentansprüche 9 bis 13,
**dadurch gekennzeichnet, dass** in Schritt h) eine zur Stegschicht (11) und zur Bitleitungsschicht (10) selektive Ätzstoppschicht als dritte Isolierschicht (9) ausgebildet wird.

15. Verfahren nach einem der Patentansprüche 9 bis 14,
**dadurch gekennzeichnet, dass** in Schritt b) die ladungsspeichernde Schicht (3) als elektrisch leitende oder elektrisch nicht leitende Einzel- oder Mehrfachschicht ausgebildet wird.

16. Verfahren nach einem der Patentansprüche 9 bis 15,
**dadurch gekennzeichnet, dass** in Schritt h) eine Siliziumnitridschicht ausgebildet wird.

17. Verfahren nach Patentanspruch 13,
**dadurch gekennzeichnet, dass** die Bitleitungsschicht (10) und die Source-/Draingebiete (S/D) vom gleichen Leitungstyp sind.

## Claims

1. Nonvolatile semiconductor memory cell having an active region (AA) formed in a substrate (1) and serving to release source/drain regions (S/D);
a first insulating layer (2) formed on the substrate (1),
a charge-storing layer (3) formed on the first insulating layer (2),
a second insulating layer (4) formed on the charge-storing layer (3), and
a control layer (5) formed on the second insulating layer (4), which together realize word line stacks (WLx);
an insulating protective layer (6, 7, 8) surrounding at least the word line stacks (WLx); and
a third insulating layer (9), which is formed over the whole area on the substrate (1) and the insulated word line stacks (WLx);
**characterized in that**
the third insulating layer (9) has openings (O) above at least partial regions of the source and drain regions (S/D); and
insulating webs (11) are formed on the third insulating layer (9) perpendicular to the word line stacks (WLx), at the sidewalls of which a source line (SL2) and a drain line (DL1) are in each case formed, wherein, between two directly adjacent insulating webs (11), the source line (SL1) and the drain line (DL1) are formed as spacers and separately from one another, and wherein the source and drain lines (SL1, DL1) each directly make contact with the source/drain regions (S/D) via the openings (O) in the third insulating layer (9).

2. Nonvolatile semiconductor memory cell as claimed in Patent Claim 1,
**characterized in that** the source and drain lines (SL2, DL1) have doped polysilicon.

3. Nonvolatile semiconductor memory cell as claimed in either of Patent Claims 1 and 2,
**characterized in that** the insulating web (11) has TEOS oxide.

4. Nonvolatile semiconductor memory cell as claimed in one of Patent Claims 1 to 3,
**characterized in that** the third insulating layer (9) has a nitride layer.

5. Nonvolatile semiconductor memory cell as claimed in one of Patent Claims 1 to 4,
**characterized in that** the charge-storing layer (3) has an electrically conductive or electrically nonconductive layer.

6. Nonvolatile semiconductor memory cell as claimed in one of Patent Claims 1 to 5,
**characterized in that** the source and drain lines (SL1, DL1) partially or completely cover the openings (O).

7. Nonvolatile semiconductor memory cell as claimed in one of Patent Claims 1 to 6,
**characterized in that** the first insulating layer (2) has a tunnel oxide and the second insulating layer (4) has a coupling oxide.

8. Nonvolatile semiconductor circuit arrangement having a multiplicity of semiconductor memory cells as claimed in one of Patent Claims 1 to 7 arranged in matrix form,
**characterized in that** the active regions (AA), the insulating webs (11) and the respective source and drain lines (SL1, DL1) are arranged in column form;
the control layers (5) for forming word lines are essentially arranged in row form; and
the openings (O) in the third insulating layer (9) are essentially arranged in zigzag form in such a way that the active regions (AA) are at least partially uncovered.

9. Method for fabricating a semiconductor circuit arrangement having the following steps:
a) formation of essentially straight active regions (AA) in a substrate (1);
b) formation of a first insulating layer (2) on the substrate, and a charge-storing layer (3) on the first insulating layer (2);
c) patterning of the charge-storing layer (3) in an x direction;
d) formation of a second insulating layer (4) on the charge-storing layer (3), a control layer (5) on the second insulating layer (4) and a partial protective layer (6) on the control layer (5);
e) patterning of the partial protective layer (6), the control layer (5), the second insulating layer (4) and the charge-storing layer (3) in a y direction for the purpose of forming essentially straight word line stacks (WLx);
f) formation of source/drain regions (S/D) in the active region (AA) of the substrate (1);
g) formation of spacers (7) on the sidewalls of the word line stacks (WLx) and removal of the first insulating layer (2) that is not covered;
h) whole-area formation of a third insulating layer (9) on the substrate (1);
i) formation of openings (O) in the third insulating layer (9) for the purpose of at least partially uncovering the active regions (AA);
j) formation of an insulating web layer (11) on the third insulating layer (9);
k) patterning of the web layer in a y direction for the purpose of forming insulating webs (11) perpendicular to the word line stacks (WLx);
l) formation of a bit line layer (10); and
m) withdrawal of the bit line layer (10) for the purpose of forming source and drain lines (SL1, DL1) on sidewalls of the insulating webs (11), wherein, between two directly adjacent insulating webs, the source line (SL1) and the drain line (DL1) are formed as spacers and separately from one another.

10. Method as claimed in Patent Claim 9,
**characterized in that** an anisotropic dry etching is carried out in step m).

11. Method as claimed in either of Patent Claims 9 and 10,
**characterized in that** the formation of the openings (O) in step i) and the withdrawal in step m) are carried out in such a way that the source and drain lines (SL2, DL1) overlap the third insulating layer (9) at the openings (0).

12. Method as claimed in one of Patent Claims 9 to 11, **characterized by**
the further step n) removal of end regions of the source and drain lines (SL1, DL1) at the end of the insulating webs (11).

13. Method as claimed in one of Patent Claims 9 to 12,
**characterized in that**, in step l), an in situ-doped polysilicon layer is deposited as bit line layer (10).

14. Method as claimed in one of Patent Claims 9 to 13,
**characterized in that**, in step h), an etching stop layer which is selective with respect to the web layer (11) and with respect to the bit line layer (10) is formed as third insulating layer (9).

15. Method as claimed in one of Patent Claims 9 to 14,
**characterized in that**, in step b), the charge-storing layer (3) is formed as an electrically conductive or electrically nonconductive monolayer or multilayer.

16. Method as claimed in one of Patent Claims 9 to 15,
**characterized in that** a silicon nitride layer is formed in step h).

17. Method as claimed in Patent Claim 13,
**characterized in that** the bit line layer (10) and the source/drain regions (S/D) are of the same conduction type.

## Revendications

1. Cellule de mémoire à semiconducteur non volatile comprenant :
une région (AA) active formée dans un substrat (1) pour la réalisation de zones (S/D) de source/drain ;
une première couche (2) isolante formée sur le substrat (1) ;
une couche (3) d'emmagasinage de charges formée sur la première couche (2) isolante ;
une deuxième couche (4) isolante formée sur la couche (3) d'emmagasinage de charges, ainsi que
une couche (5) de commande, qui réalise conjointement un empilement (WLx) de lignes de mots ;
une couche (6, 7, 8) de protection isolante entourant au moins l'empilement (WLx) de lignes de mots ; et
une troisième couche (9) isolante, qui est formée sur toute la surface sur le substrat (1) et sur l'empilement (WLx) de lignes de mots isolé, **caractérisée en ce que**
la troisième couche (9) isolante a des ouvertures (0) sur au moins des régions partielles des zones (S/D) de source et de drain ; et
sur la troisième couche (9) isolante sont formées des nervures (11) isolantes perpendiculairement aux empilements (WLx) de lignes de mots, sur les parois latérales desquelles sont formées respectivement une ligne (SL2) de source et une ligne (DL1) de drain, la ligne (SL1) de source et la ligne (DL1) de drain étant formées comme espaceur séparément l'une de l'autre entre deux nervures (11) isolantes directement voisines, et dans laquelle
la ligne (SL1) de source et la ligne (DL1) de drain touchent respectivement directement les zones (S/D) de source/drain par les ouvertures (O) dans la troisième couche (9) isolante.

2. Cellule de mémoire à semiconducteur non volatile suivant la revendication 1,
**caractérisée en ce que** la ligne (SL2) de source et la ligne (DL1) de drain comprennent du polysilicium dopé.

3. Cellule de mémoire à semiconducteur non volatile suivant l'une des revendications 1 ou 2,
**caractérisée en ce que** la nervure (11) isolante comporte de l'oxyde TEOS.

4. Cellule de mémoire à semiconducteur non volatile suivant l'une des revendications 1 à 3,
**caractérisée en ce que** la troisième couche (9) isolante comporte une couche de nitrure.

5. Cellule de mémoire à semiconducteur non volatile suivant l'une des revendications 1 à 4,
**caractérisée en ce que** la couche (3) d'emmagasinage de charges comporte une couche conductrice de l'électricité ou non conductrice de l'électricité.

6. Cellule de mémoire à semiconducteur non volatile suivant l'une des revendications 1 à 5,
**caractérisée en ce que** les lignes (SL1, DL1) de source et de drain recouvrent en tout ou partie les ouvertures (O).

7. Cellule de mémoire à semiconducteur non volatile suivant l'une des revendications 1 à 6,
**caractérisée en ce que** la première couche (2) isolante comporte un oxyde de tunnel et la deuxième couche (4) isolante un oxyde de couplage.

8. Agencement de circuit à semiconducteur non volatile, comprenant une pluralité de cellules de mémoire à semiconducteur disposées en forme de matrice suivant l'une des revendications 1 à 7,
**caractérisé en ce que** les régions (AA) actives, les nervures (11) isolantes et les lignes (SL1, DL1) respectives de source et de drain sont disposées sous forme de colonne ;
les couches (5) de commande de formation de lignes de mots sont disposées sensiblement sous forme de ligne ; et
les ouvertures (0) dans la troisième couche (9) isolante sont disposées sensiblement sous forme de zigzag, de sorte que les régions (AA) actives soient dénudées, au moins en partie.

9. Procédé de production d'un agencement de circuit à semiconducteur, comprenant les stades dans lesquels :
a) on forme des régions (AA) actives sensiblement droites dans un substrat (1) ;
b) on forme une première couche (2) isolante sur le substrat (1) et une couche (3) d'emmagasinage de charges sur la première couche (2) isolante ;
c) on structure la couche (3) d'emmagasinage de charges dans une direction x ;
d) on forme une deuxième couche (4) isolante sur la couche (3) d'emmagasinage, une couche (5) de commande sur la deuxième couche (4) isolante et une couche (6) de protection partielle sur la couche (5) de commande ;
e) on structure la couche (6) de production partielle, la couche (5) de commande, la deuxième couche (4) isolante et la couche (3) d'emmagasinage de charges dans une direction y pour la formation d'empilements (WLx) de lignes de mots sensiblement droits ;
f) on forme des zones (S/D) de source/drain dans la région (AA) active du substrat (1) ;
g) on forme des espaceurs (7) sur les parois latérales des empilements (WLx) de lignes de mots et on élimine la première couche (2) isolante non recouverte ;
h) on forme sur toute la surface une troisième couche (9) isolante sur le substrat (1) ;
i) on forme des ouvertures (0) dans la troisième couche (9) isolante pour mettre à nu, au moins en partie, les régions (AA) actives ;
j) on forme une couche (11) de nervures isolantes sur la troisième couche (9) isolante ;
k) on structure la couche de nervure dans une direction y pour la formation de nervures (11) isolantes perpendiculairement aux empilements (WLx) de lignes de mots ;
l) on forme une couche (10) de lignes de bits ; et
m) on reforme la couche (10) de lignes de bits pour la formation de lignes (SL1, DL1) de source et de drain sur les parois latérales des nervures (11) isolantes, dans lequel, entre deux nervures isolantes voisines directement, la ligne (SL1) de source et la ligne (DL1) de drain sont constituées en espaceur et séparément l'une de l'autre.

10. Procédé suivant la revendication 9,
**caractérisé en ce que**, dans le stade m), on effectue une attaque à sec anisotrope.

11. Procédé suivant l'une des revendications 9 ou 10,
**caractérisé en ce qu'**on effectue la formation des ouvertures (0) dans le stade i) et la reformation dans le stade m), de manière à ce que les lignes (SL2, DL1) de source et de drain chevauchent la troisième couche (9) isolante sur les ouvertures (11).

12. Procédé suivant l'une des revendications 9 à 11,
**caractérisé par** le stade supplémentaire n), on élimine des régions d'extrémité des lignes (SL1, DL1) de source et de drain à l'extrémité des nervures (11) isolantes.

13. Procédé suivant l'une des revendications 9 à 12,
**caractérisé en ce que**, dans le stade 1), on dépose une couche de polysilicium dopé in situ comme couche (10) de lignes de bits.

14. Procédé suivant l'une des revendications 9 à 13,
**caractérisé en ce que**, dans le stade h), on forme comme troisième couche (9) isolante une couche d'arrêt d'attaque sélective par rapport à la couche (11) de nervures et par rapport à la couche (10) de lignes de bits.

15. Procédé suivant l'une des revendications 9 à 14,
**caractérisé en ce que**, dans le stade b), on forme la couche (3) d'emmagasinage de charges en tant que couche individuelle ou multiple conductrice de l'électricité ou non conductrice de l'électricité.

16. Procédé suivant l'une des revendications 9 à 15,
**caractérisé en ce que**, dans le stade h), on forme une couche de nitrure de silicium.

17. Procédé suivant la revendication 13,
**caractérisé en ce que** la couche (10) de lignes de bits et les zones (S/D) de source et de drain sont du même type de conductivité.
